# EUROPEAN PATENT APPLICATION

(11) **EP 4 596 164 A1**
(43) Date of publication of application: **06.08.2025**
(21) Application number: 23869965.6
(22) Date of filing: 31.07.2023
(51) Int. Cl.: B23K 31/02, B23K 37/04, H01L 31/18, H01L 31/05, B23K 101/36

(54) **DOUBLE-SIDED WELDING METHOD FOR SOLAR CELL SHEET**

(30) Priority: 27.09.2022 CN 202211183626
(71) Applicant: Changzhou Shichuang Energy Co., Ltd, Changzhou, Jiangsu 213300 (CN)
(72) Inventor: WANG, Weiliang, hangzhou, Jiangsu 213300 (CN); CHEN, Zhangyang, Pingxiang, Jiangxi 337000 (CN); CAO, Yuhong, Nanjing, Jiangsu 211100 (CN)
(74) Representative: Miller, Ronald Anthony
(86) International application number: PCT/CN2023/110135
(87) International publication number: WO 2024/066719

(57) **Abstract**

A double-sided soldering method for a solar cell includes following steps: providing, on an outer surface of a soldering carrier, a bearing surface provided with a routing groove, routing a first strip-shaped conductive connection member in the routing groove, attaching a cell to the bearing surface, tightening and attaching a second strip-shaped conductive connection member to an outer side surface of the cell, such that the second strip-shaped conductive connection member firmly presses the cell onto the first strip-shaped conductive connection member protruding from the bearing surface, and heating the first strip-shaped conductive connection member and the second strip-shaped conductive connection member, such that the first strip-shaped conductive connection member and the second strip-shaped conductive connection member are soldered on the cell.

## Description

### TECHNICAL FIELD

The present disclosure relates to the field of photovoltaics, and specifically, to a double-sided soldering method for a solar cell.

### BACKGROUND

In a conventional manufacturing process of a crystalline silicon photovoltaic module, a first step is to solder solder ribbons for cells and connect the cells in series to form a cell string. Specifically, the method for forming a cell string is as follows. Solder ribbons and cells are alternately arranged in sequence, where a length of each of the solder ribbons is approximately twice a width of each of the cells, such that half of each of the solder ribbons is on a front surface of a respective cell and the other half of each of the solder ribbons is on a back surface of an adjacent cell. In this way, a cell string including a plurality of cells with upper and lower surfaces (namely positive and negative electrodes) being connected in series is formed in sequence. The cell string is then transported to a soldering station via an adsorption track. Generally, a plurality of pressure wires or pressure blocks are used to firmly press upper and lower solder ribbons against the cell. Through infrared heating, the solder ribbon is soldered onto the electrode on the surface of the cell.

When the solder ribbon is soldered onto the cell, the cell is generally placed flat on a flat and straight bearing surface. The solder ribbon is pressed against the cell mainly through a wire mesh or the pressure block that is perpendicular to a direction of the solder ribbon to make the solder ribbon be in contact with the cell for soldering. The solder ribbon is pressed at several scattered points, and it is impossible to ensure the effective contact for the unpressed area of the solder ribbon. Especially, when the solder ribbon is heated, the unpressed area of the solder ribbon is prone to elongation and distortion, resulting in a soldering failure. Additionally, when one pressure wire is used to press a plurality of solder ribbons perpendicularly in a crossed manner at one time, a middle solder ribbon fails to be effectively pressed due to insufficient pressure or the suspension of the pressure wire. This leads to ineffective soldering at the corresponding area. Consequently, the conventional process for soldering the solder ribbon onto the cell frequently suffers from dry solder joints.

In addition, in a photovoltaic module, specially-shaped solder ribbons such as triangular solder ribbons with optical advantages are increasingly being applied. In the conventional soldering process, it is difficult to ensure the direction consistency for the specially-shaped solder ribbons such as triangular solder ribbons through clamping, transporting, pressing, and the like, and it is also difficult to prevent the specially-shaped solder ribbons such as triangular solder ribbons from flipping over across an entire surface of the cell. Therefore, for the specially-shaped solder ribbons, especially ultra-fine specially-shaped solder ribbons, a novel soldering method and process is required to effectively ensure the orientation consistency, in order to effectively solder the specially-shaped solder ribbons.

Furthermore, in the development of photovoltaic technologies, increasing the number of busbars and silicon wafer thinning are still important directions for the development of cell module technologies. The pattern for collecting the current on the surface of the cell is a finger. Comprehensively considering the shading of light and the transmission loss of the current, the aspect ratio of the finger should be as large as possible. The pattern for connecting the cells in series and collecting the currents from the fingers is a busbar. To a certain extent, more busbars lead to a less silver consumption of the fingers, a narrower pattern, and a lower loss caused by the thermal resistance of the fingers, which can improve the efficiency while reducing the silver consumption of the cell. Consequently, a cell design continues to develop toward a configuration with more busbars. The cost of crystalline silicon accounts for about half of the cost of the photovoltaic module. A thicker silicon wafer leads to the more crystalline silicon material to be used and the higher cost of the crystalline silicon. Therefore, the application of a thin silicon wafer is also an important direction for the development of the photovoltaic module.

When more busbars are used for the cell, more and thinner solder ribbons are required. Currently, the diameter of the smallest round-wire solder ribbon used is less than 0.2 mm, and there are as many as 30 solder ribbons on a cell with a width of 210 mm. The conventional soldering device mainly uses clamps to grasp, pull, transport, and place the solder ribbons, and reduces deviation, rolling, and twisting of the solder ribbons through pressing via the pressure block. With so many and thin solder ribbons, the control complexity of the conventional soldering process increases dramatically. 1) One solder ribbon corresponds to one spool, and therefore, a large number of spools makes it difficult to design the spool position and perform pay-off, routing, and alignment at the same time. 2) Automation also requires a matching design that shortens the flow path of the solder wire and the cell, positions the solder ribbon, and ensures the upstream and downstream matching between various actions. 3) The influence from device disconnection and other failures has greatly increased, post-failure recovery is challenging, and the complexity of device maintenance also rises substantially.

### SUMMARY

### TECHNICAL PROBLEMS

### SOLUTIONS TO PROBLEMS

### TECHNICAL SOLUTIONS

An objective of the present disclosure is to provide a double-sided soldering method for a solar cell, including respectively soldering strip-shaped conductive connection members to two side surfaces of a cell (namely a front surface and a back surface of the cell), where the strip-shaped conductive connection members include a first strip-shaped conductive connection member and a second strip-shaped conductive connection member, the first strip-shaped conductive connection member and the second strip-shaped conductive connection member are respectively disposed on the two side surfaces of the cell, and the double-sided soldering method for the solar cell includes following steps:
providing, on an outer surface of a soldering carrier, a bearing surface for attaching the cell, enabling the bearing surface to be an outwardly protruding cambered surface (which may be an arc surface), and disposing a routing groove for placing the first strip-shaped conductive connection member on the bearing surface, where the routing groove is extended along a circumferential direction of the bearing surface (namely, an extension direction of the routing groove is perpendicular to an axis of the bearing surface) and the routing groove is a through groove on the bearing surface;
pre-placing the first strip-shaped conductive connection member, where the first strip-shaped conductive connection member is routed in the routing groove (the routing groove restricts the first strip-shaped conductive connection member in the routing groove to extend in an identical direction to the routing groove), and the first strip-shaped conductive connection member is allowed to protrude from the routing groove (namely, the first strip-shaped conductive connection member is allowed to protrude from the bearing surface);
attaching the cell to the bearing surface, ensuring that the cell does not extend beyond the bearing surface to which the cell is attached, allowing a side surface of the cell to face the bearing surface to be an inner side surface of the cell, and attaching the inner side surface of the cell (namely, the side surface of the cell facing the bearing surface) to the first strip-shaped conductive connection member protruding from the bearing surface, where the first strip-shaped conductive connection member is to be soldered on the side surface of the cell (namely, allowing a side surface of the cell on which the second strip-shaped conductive connection member is to be soldered to be opposite to the bearing surface);
tightening and attaching the second strip-shaped conductive connection member to an outer side surface of the cell (namely, to the side surface of the cell opposite to the bearing surface) along the circumferential direction of the bearing surface, such that the second strip-shaped conductive connection member firmly presses the cell onto the first strip-shaped conductive connection member protruding from the bearing surface; and
heating the first strip-shaped conductive connection member and the second strip-shaped conductive connection member, such that the first strip-shaped conductive connection member and the second strip-shaped conductive connection member are soldered on the cell (the step of respectively soldering the strip-shaped conductive connection members to the two side surfaces of the cell is completed).

Preferably, if the inner side surface of the cell is provided with a plurality of grid lines parallel to each other, a plurality of routing grooves parallel to each other are disposed on the bearing surface (the plurality of routing grooves on the bearing surface respectively correspond to the plurality of grid lines on the inner side surface of the cell attached to the bearing surface), such that the plurality of routing grooves are each extended along the circumferential direction of the bearing surface (namely, an extension direction of the plurality of routing grooves is perpendicular to the axis of the bearing surface), and each of the plurality of routing grooves is a through groove. Moreover, when the first strip-shaped conductive connection member is pre-placed, the first strip-shaped conductive connection member is routed in each of the plurality of routing grooves (the routing groove restricts the first strip-shaped conductive connection member in the routing groove to extend in an identical direction to the routing groove), and the first strip-shaped conductive connection member is allowed to protrude from the routing groove in which the first strip-shaped conductive connection member is located (namely, the first strip-shaped conductive connection member is allowed to protrude from the bearing surface). When the cell is attached to the bearing surface, an extension direction of the plurality of grid lines on the inner side surface of the cell is allowed to be perpendicular to the axis of the bearing surface, and the plurality of grid lines on the inner side surface of the cell are correspondingly attached to the first strip-shaped conductive connection member protruding from the bearing surface in the plurality of routing grooves on the bearing surface.

Preferably, if the outer side surface of the cell is provided with a plurality of grid lines parallel to each other (the plurality of grid lines on the outer side surface of the cell are parallel to the plurality of grid lines on the inner side surface of the cell), when the second strip-shaped conductive connection member is tightened and attached to the outer side surface of the cell, the second strip-shaped conductive connection member is correspondingly attached to the plurality of grid lines on the outer side surface of the cell.

Preferably, after the first strip-shaped conductive connection member and the second strip-shaped conductive connection member are soldered on the cell, the first strip-shaped conductive connection member and the second strip-shaped conductive connection member are cut off to leave a small section of the first strip-shaped conductive connection member and a small section of the second strip-shaped conductive connection member on the cell, and the small section of the first strip-shaped conductive connection member and the small section of the second strip-shaped conductive connection member are configured for a serial connection of the cell on which the small section of the first strip-shaped conductive connection member and the small section of the second strip-shaped conductive connection member are located (one end of the small section of the first strip-shaped conductive connection member and one end of the small section of the second strip-shaped conductive connection member extend beyond the cell on which the small section of the first strip-shaped conductive connection member and the small section of the second strip-shaped conductive connection member are located, and the other end of the small section of the first strip-shaped conductive connection member and the other end of the small section of the second strip-shaped conductive connection member do not extend beyond the cell on which the small section of the first strip-shaped conductive connection member and the small section of the second strip-shaped conductive connection member are located); and then the cell is removed from the bearing surface of the soldering carrier.

For a specific selection of the first strip-shaped conductive connection member and the second strip-shaped conductive connection member, a specific implementation of pre-placing the first strip-shaped conductive connection member, a specific implementation of tightening and attaching the second strip-shaped conductive connection member to the outer side surface of the cell, a specific implementation of heating the first strip-shaped conductive connection member and the second strip-shaped conductive connection member, and other related specific details, reference can be made to embodiments.

### BENEFICIAL EFFECTS OF THE PRESENT DISCLOSURE

### BENEFICIAL EFFECTS

The present disclosure has following advantages and beneficial effects.

The present disclosure can synchronously solder the strip-shaped conductive connection members to the two side surfaces of the cell respectively, which can simplify the process of respectively soldering the strip-shaped conductive connection members (solder wires or solder ribbons) to the two side surfaces of the cell, optimize the effective contact between the cell and the strip-shaped conductive connection members (the solder wires or the solder ribbons) respectively on the two side surfaces of the cell, improve the soldering performance, and enhance the soldering efficiency.

In the present disclosure, the bearing surface of the soldering carrier is the outwardly protruding cambered surface, the first strip-shaped conductive connection member (the solder wire or the solder ribbon) is pre-placed in the routing groove extending along the circumferential direction of the bearing surface, and the cell is attached to the bearing surface. In addition, the cell is attached to the first strip-shaped conductive connection member protruding from the bearing surface, and the second strip-shaped conductive connection member (the solder wire or the solder ribbon) is tightened and attached to the cell along the circumferential direction of the cambered surface of the bearing surface, such that the second strip-shaped conductive connection member firmly presses the cell onto the first strip-shaped conductive connection member protruding from the bearing surface. During the soldering, the first strip-shaped conductive connection member (the solder wire or the solder ribbon), the cell, and the second strip-shaped conductive connection member (the solder wire or the solder ribbon) are bent on the bearing surface along the circumferential direction of the cambered surface of the bearing surface, such that the cell and each of the first strip-shaped conductive connection member and the second strip-shaped conductive connection member (the solder wire or the solder ribbon) can be continuously and sufficiently attached together, sufficiently stressed, and fully in contact with each other.

The present disclosure can wind and solder the strip-shaped conductive connection members (the first strip-shaped conductive connection member and the second strip-shaped conductive connection member) to a plurality of rows of cells at a time, and solder the strip-shaped conductive connection members (the first strip-shaped conductive connection member and the second strip-shaped conductive connection member) to the two side surfaces of each cell of the plurality of rows of cells at a time, thereby improving the soldering efficiency.

The present disclosure also has the following advantages.

The present disclosure reduces dry solder joints. Because the first strip-shaped conductive connection member (the solder wire or the solder ribbon), the second strip-shaped conductive connection member (the solder wire or the solder ribbon), and the cell can be continuously attached together and uniformly stressed, the soldering is completed where the first strip-shaped conductive connection member and the second strip-shaped conductive connection member are in full contact with the cell under stress. Therefore, the soldering is complete and sufficient, which can greatly reduce the dry solder joints.

In the present disclosure, a small number of spools are used for the first strip-shaped conductive connection member (the solder wire or the solder ribbon) and the second strip-shaped conductive connection member (the solder wire or the solder ribbon), and can be easily controlled.

In the present disclosure, only one first strip-shaped conductive connection member is wound and routed in all routing grooves on the soldering carrier, and the first strip-shaped conductive connection member (the solder wire or solder ribbon) in all the routing grooves on the soldering carrier comes from the same spool. The present disclosure can use only one second strip-shaped conductive connection member for winding around all cells on the soldering carrier, and the second strip-shaped conductive connection member (the solder wire or solder ribbon) for all the cells on the soldering carrier comes from the same spool. Therefore, the number of spools is greatly reduced, which can simplify the design of device space. Maintenance and wire replacement operations for faults such as wire breakage and deviation of the first strip-shaped conductive connection member (the solder wire or the solder ribbon) and the second strip-shaped conductive connection member (the solder wire or the solder ribbon) are also greatly simplified.

In the present disclosure, minimal deviation of the first strip-shaped conductive connection member (the solder wire or the solder ribbon) and the second strip-shaped conductive connection member (the solder wire or the solder ribbon) is achieved in the winding process. The first strip-shaped conductive connection member (the solder wire or the solder ribbon) can be directly connected to the side circumferential surface of the soldering carrier after being pulled out from the spool, routed and wound along the routing groove, and pulled tight to the side circumferential surface of the soldering carrier, which can completely eliminate the conventional actions of cutting, clamping, stretching, and transporting the first strip-shaped conductive connection member (the solder wire or the solder ribbon), and almost completely avoid the possible deviation of the first strip-shaped conductive connection member (the solder wire or the solder ribbon). The second strip-shaped conductive connection member (the solder wire or the solder ribbon) can be directly connected to the cell after being pulled out from the spool, aligned with the grid lines on the cell, and tightened and fixed, which can completely eliminate the conventional actions of cutting, clamping, stretching, and transporting the second strip-shaped conductive connection member (the solder wire or the solder ribbon), and almost completely avoid the possible deviation of the second strip-shaped conductive connection member (the solder wire or the solder ribbon).

In the present disclosure, a large number of, e.g. hundreds of, small sections of the first strip-shaped conductive connection member, and a large number of, e.g. hundreds of, small sections of the second strip-shaped conductive connection member can be formed at a time through soldering the first strip-shaped conductive connection member and the second strip-shaped conductive connection member on a single cell (the small section of the first strip-shaped conductive connection member and the small section of the second strip-shaped conductive connection member are configured for the serial connection of the cell on which the small section of the first strip-shaped conductive connection member and the small section of the second strip-shaped conductive connection member are located). Theoretically, the final number of small sections of the first strip-shaped conductive connection member on the single cell is equal to the number of rotation turns of the side circumferential surface of the soldering carrier when the first strip-shaped conductive connection member is wound, and the final number of small sections of the second strip-shaped conductive connection member on the single cell is equal to the number of rotation turns of the side circumferential surface of the soldering carrier when the second strip-shaped conductive connection member is wound. This makes it easy to control and implement.

The present disclosure can be applied to soldering of a specially-shaped solder ribbon (such as a triangular solder ribbon) that requires direction recognition. When the first strip-shaped conductive connection member is a triangular solder ribbon, the routing groove (V-shaped groove) is configured to support the triangular solder ribbon routed in the routing groove to keep the bottom surface of the triangular solder ribbon facing outwards, so as to prevent the triangular solder ribbon from twisting when being routed in the routing groove. This can ultimately allow the bottom surface of the triangular solder ribbon to face the inner side surface of the cell, such that finally, the first strip-shaped conductive connection member (the triangular solder ribbon) can be stably attached to the corresponding grid line on the inner side surface of the cell. When the second strip-shaped conductive connection member is a triangular solder ribbon, the bearing surface (the outwardly protruding cambered surface) can automatically correct the direction of a top corner of the triangular solder ribbon, such that the top corner of the triangular solder ribbon faces upwards and the bottom surface of the triangular solder ribbon faces downwards. In the present disclosure, the specially-shaped solder ribbon (such as the triangular solder ribbon) can be soldered. The triangular solder ribbon is not liable to flip and achieves a high yield.

### BRIEF DESCRIPTION OF THE DRAWINGS

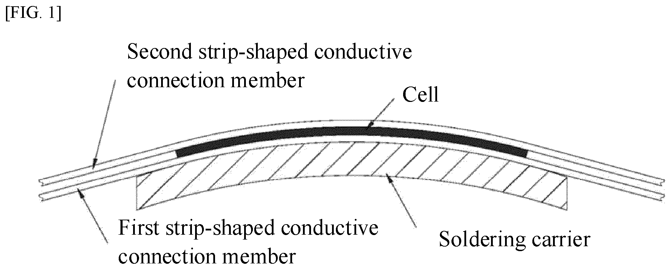

FIG. 1 to FIG. 5 are schematic diagrams of the present disclosure.

### DETAILED DESCRIPTION OF THE EMBODIMENTS

### IMPLEMENTATIONS OF THE INVENTION

The specific implementations of the present disclosure will be described in detail below with reference to the accompanying drawings and embodiments. The following embodiments are only used for describing the technical solutions of the present disclosure more clearly, and are not intended to limit the protection scope of the present disclosure.

The present disclosure provides a double-sided soldering method for a solar cell, including respectively soldering strip-shaped conductive connection members to two side surfaces of a cell (namely a front surface and a back surface of the cell), where the strip-shaped conductive connection members include a first strip-shaped conductive connection member and a second strip-shaped conductive connection member that are respectively disposed on the two side surfaces of the cell, and the double-sided soldering method for the solar cell includes following steps.

A bearing surface for attaching the cell is provided on an outer surface of a soldering carrier, the bearing surface is enabled to be an outwardly protruding cambered surface (which may be an arc surface), and an arch height of the cambered surface is not greater than one fourth of an arc length, and a routing groove for placing the first strip-shaped conductive connection member is disposed on the bearing surface, where the routing groove is extended along a circumferential direction of the bearing surface (namely, an extension direction of the routing groove is perpendicular to an axis of the bearing surface) and the routing groove is a through groove on the bearing surface.

The first strip-shaped conductive connection member is pre-placed, where the first strip-shaped conductive connection member is routed in the routing groove (the routing groove restricts the first strip-shaped conductive connection member in the routing groove to extend in an identical direction to the routing groove), and the first strip-shaped conductive connection member is allowed to protrude from the routing groove (namely, the first strip-shaped conductive connection member is allowed to protrude from the bearing surface).

Then the cell is attached to the bearing surface, it is ensured that the cell does not extend beyond the bearing surface to which the cell is attached, a side surface of the cell on which the first strip-shaped conductive connection member is to be soldered is allowed to face the bearing surface to be an inner side surface of the cell (namely, a side surface of the cell on which the second strip-shaped conductive connection member is to be soldered is allowed to be opposite to the bearing surface), and the inner side surface of the cell (namely, the side surface of the cell facing the bearing surface) is attached to the first strip-shaped conductive connection member protruding from the bearing surface.

Then the second strip-shaped conductive connection member is tightened and attached to an outer side surface of the cell (namely, to the side surface of the cell opposite to the bearing surface) along the circumferential direction of the bearing surface, such that the second strip-shaped conductive connection member firmly presses the cell onto the first strip-shaped conductive connection member protruding from the bearing surface.

Then the first strip-shaped conductive connection member and the second strip-shaped conductive connection member are heated through direct heating, infrared heating, hot air heating, or the like, such that the first strip-shaped conductive connection member and the second strip-shaped conductive connection member are soldered on the cell.

Then the first strip-shaped conductive connection member and the second strip-shaped conductive connection member are cut off to leave a small section of the first strip-shaped conductive connection member and a small section of the second strip-shaped conductive connection member on the cell, and the small section of the first strip-shaped conductive connection member and the small section of the second strip-shaped conductive connection member are configured for a serial connection of the cell on which the small section of the first strip-shaped conductive connection member and the small section of the second strip-shaped conductive connection member are located (one end of the small section of the first strip-shaped conductive connection member and one end of the small section of the second strip-shaped conductive connection member extend beyond the cell on which the small section of the first strip-shaped conductive connection member and the small section of the second strip-shaped conductive connection member are located, and the other end of the small section of the first strip-shaped conductive connection member and the other end of the small section of the second strip-shaped conductive connection member do not extend beyond the cell on which the small section of the first strip-shaped conductive connection member and the small section of the second strip-shaped conductive connection member are located).

Then the cell is removed from the bearing surface of the soldering carrier (the step of respectively soldering the strip-shaped conductive connection members to the two side surfaces of the cell is completed).

Specifically:
1) The bearing surface can be provided with a vacuum adsorption function (for example, suction ports can be uniformly distributed on the bearing surface for a vacuum adsorption). In addition, when the cell is attached to the bearing surface, the vacuum adsorption is performed on the cell through the bearing surface to ensure that the cell is stably adsorbed on the bearing surface.
2) The soldering carrier can be provided with a heating function, and the first strip-shaped conductive connection member and the cell on the bearing surface and the second strip-shaped conductive connection member on the outer side surface of the cell are heated through the soldering carrier.
3) If the inner side surface of the cell is provided with a plurality of grid lines parallel to each other,
   a plurality of routing grooves parallel to each other are disposed on the bearing surface (the plurality of routing grooves on the bearing surface respectively correspond to the plurality of grid lines on the inner side surface of the cell attached to the bearing surface), such that the plurality of routing grooves are each extended along the circumferential direction of the bearing surface (namely, an extension direction of the plurality of routing grooves is perpendicular to the axis of the bearing surface), and each of the plurality of routing grooves is a through groove.

Moreover, when the first strip-shaped conductive connection member is pre-placed, the first strip-shaped conductive connection member is routed in each routing groove (the routing groove restricts the first strip-shaped conductive connection member in the routing groove to extend in an identical direction to the routing groove), and the first strip-shaped conductive connection member is allowed to protrude from the routing groove in which the first strip-shaped conductive connection member is located (namely, the first strip-shaped conductive connection member is allowed to protrude from the bearing surface).

When the cell is attached to the bearing surface, an extension direction of the plurality of grid lines on the inner side surface of the cell is allowed to be perpendicular to the axis of the bearing surface, and the plurality of grid lines on the inner side surface of the cell are correspondingly attached to the first strip-shaped conductive connection member protruding from the bearing surface in the plurality of routing grooves on the bearing surface.

4) If the outer side surface of the cell is provided with a plurality of grid lines parallel to each other (the plurality of grid lines on the outer side surface of the cell are parallel to the plurality of grid lines on the inner side surface of the cell),
when the second strip-shaped conductive connection member is tightened and attached to the outer side surface of the cell, the second strip-shaped conductive connection member is correspondingly attached to the plurality of grid lines on the outer side surface of the cell.

5) The strip-shaped conductive connection members (the first strip-shaped conductive connection member and the second strip-shaped conductive connection member) may be a solder wire or a solder ribbon.

If the strip-shaped conductive connection members (the first strip-shaped conductive connection member and the second strip-shaped conductive connection member) each have a flat and straight bottom surface for soldering to the cell (for example, the first strip-shaped conductive connection member and the second strip-shaped conductive connection member each have a triangular or rectangular cross-section),
the routing groove is configured to support the first strip-shaped conductive connection member routed in the routing groove to keep the flat and straight bottom surface of the first strip-shaped conductive connection member being opposite to the bearing surface, so as to prevent the first strip-shaped conductive connection member from twisting when being routed in the routing groove (for example, a cross-sectional shape of the routing groove matches that of the first strip-shaped conductive connection member, and the first strip-shaped conductive connection member is embedded into the routing groove for routing). In addition, when the first strip-shaped conductive connection member is pre-placed, the flat and straight bottom surface of the first strip-shaped conductive connection member is arranged to be opposite to the bearing surface, such that finally, the first strip-shaped conductive connection member can be stably attached to the inner side surface of the cell.

For example, the first strip-shaped conductive connection member may be a triangular solder ribbon, and the routing groove is a V-shaped groove into which a top corner of the triangular solder ribbon can be embedded. When the first strip-shaped conductive connection member is routed in the routing groove, a top corner of the first strip-shaped conductive connection member is embedded into the routing groove, and the bottom surface of the first strip-shaped conductive connection member is allowed to protrude from the routing groove.

When the second strip-shaped conductive connection member is tightened and attached to the outer side surface of the cell, the flat and straight bottom surface of the second strip-shaped conductive connection member is allowed to face the outer side surface of the cell, such that the second strip-shaped conductive connection member is stably attached to the outer side surface of the cell.

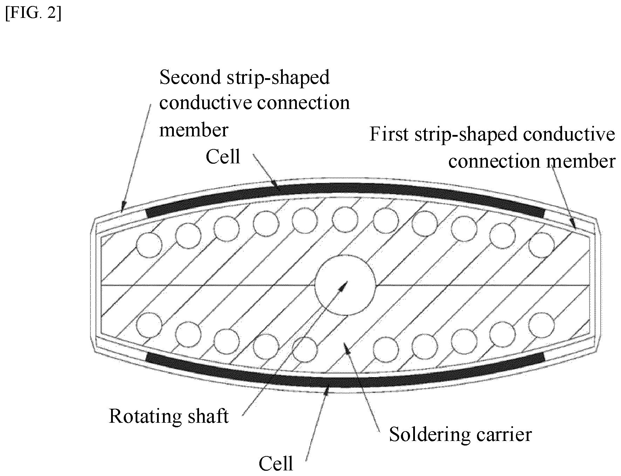

For example, the second strip-shaped conductive connection member may be a triangular solder ribbon. When the second strip-shaped conductive connection member (the triangular solder ribbon) is tightened and attached to the outer side surface of the cell, a bottom surface of the triangular solder ribbon is allowed to face the outer side surface of the cell (namely a top corner of the triangular solder ribbon is allowed to be opposite to the outer side surface of the cell), such that the second strip-shaped conductive connection member (the triangular solder ribbon) is stably attached to the outer side surface of the cell.
6) As shown in FIG. 1, the second strip-shaped conductive connection member is tightened and attached to the outer side surface of the cell by allowing the second strip-shaped conductive connection member to span across the cell along the circumferential direction of the bearing surface and pulling sections of the second strip-shaped conductive connection member respectively located outside two sides of the cell tight towards the soldering carrier and/or the bearing surface.
7) As shown in FIG. 2 to FIG. 5, a rotating shaft can also be provided on the soldering carrier, and the outer surface of the soldering carrier includes a side circumferential surface around the rotating shaft. The bearing surface is located on the side circumferential surface of the soldering carrier, and the axis of the bearing surface is parallel to or collinear with an axis of the rotating shaft. Moreover, the first strip-shaped conductive connection member is pre-placed by routing and winding the first strip-shaped conductive connection member along the routing groove and pulling the first strip-shaped conductive connection member tight to the side circumferential surface of the soldering carrier. In addition, the second strip-shaped conductive connection member is tightened and attached to the outer side surface of the cell by winding the second strip-shaped conductive connection member along a circumferential direction of the side circumferential surface of the soldering carrier and pulling the second strip-shaped conductive connection member tight to the cell on the side circumferential surface of the soldering carrier.

In addition, if the axis of the rotating shaft is located on a centerline of the soldering carrier, when the first strip-shaped conductive connection member is wound along the routing groove and pulled tight to the side circumferential surface of the soldering carrier, the side circumferential surface of the soldering carrier is rotated around the axis of the rotating shaft, making it convenient to wind the first strip-shaped conductive connection member. When the second strip-shaped conductive connection member is wound along the circumferential direction of the side circumferential surface of the soldering carrier and pulled tight to the cell on the side circumferential surface of the soldering carrier, the side circumferential surface of the soldering carrier is rotated around the axis of the rotating shaft, making it convenient to wind the second strip-shaped conductive connection member.

Moreover, only one first strip-shaped conductive connection member may be used, and the first strip-shaped conductive connection member is routed and wound along the routing groove and pulled tight to the side circumferential surface of the soldering carrier. Only one second strip-shaped conductive connection member may be used, and the second strip-shaped conductive connection member is wound along the circumferential direction of the side circumferential surface of the soldering carrier and pulled tight to the cell on the side circumferential surface of the soldering carrier.

More preferably, a plurality of rows of bearing surfaces can be provided on the side circumferential surface of the soldering carrier and are each provided with a routing groove, where the plurality of rows of bearing surfaces are sequentially disposed along the circumferential direction of the side circumferential surface of the soldering carrier, bearing surfaces in an identical row of the plurality of rows of bearing surfaces are sequentially disposed along an axial direction of the rotating shaft, and an axis of each bearing surface of the plurality of rows of bearing surfaces is parallel to or collinear with the axis of the rotating shaft. More specifically, the plurality of rows of bearing surfaces may be uniformly distributed along the circumferential direction of the side circumferential surface of the soldering carrier, and the plurality of rows of bearing surfaces may even be uniformly distributed on the side circumferential surface of the soldering carrier. A cell is attached to each bearing surface of the plurality of rows of bearing surfaces (the first strip-shaped conductive connection member is wound around the plurality of rows of bearing surfaces in advance), such that the second strip-shaped conductive connection member can be wound around a plurality of rows of cells at a time. Finally, the first strip-shaped conductive connection member and the second strip-shaped conductive connection member can be soldered to a plurality of rows of cells at a time (the first strip-shaped conductive connection member and the second strip-shaped conductive connection member can be synchronously soldered on the plurality of rows of cells), which can improve soldering efficiency.

Specific embodiments of a method for winding the first strip-shaped conductive connection member and the second strip-shaped conductive connection member in the present disclosure are as follows.

### Embodiment 1

As shown in FIG. 2, this embodiment provides a double-sided soldering method for a solar cell, including: respectively soldering strip-shaped conductive connection members to two side surfaces of a cell (namely a front face and a back surface of the cell), where the strip-shaped conductive connection members include a first strip-shaped conductive connection member and a second strip-shaped conductive connection member that are respectively disposed on the two side surfaces of the cell; an inner side surface of the cell is provided with a plurality of grid lines parallel to each other; and an outer side surface of the cell is also provided with a plurality of grid lines parallel to each other, and the plurality of grid lines on the outer side surface of the cell are parallel to the plurality of grid lines on the inner side surface of the cell.

The double-sided soldering method for the solar cell includes following steps.

A soldering carrier with a rotating shaft is provided, with an axis of the rotating shaft located on a centerline of the soldering carrier, and the soldering carrier is provided with a side circumferential surface around the rotating shaft. The side circumferential surface of the soldering carrier is provided with two bearing surfaces that are used for attaching the cell, where the two bearing surfaces are outwardly protruding cambered surfaces (which may be arc surfaces) and are symmetrically arranged, and an axis of each of the two bearing surfaces is parallel to or collinear with the axis of the rotating shaft. The two bearing surfaces are each provided with a plurality of routing grooves parallel to each other (the plurality of routing grooves on the respective bearing surface respectively correspond to the plurality of grid lines on the inner side surface of the cell attached to the respective bearing surface, and the plurality of routing grooves on the same bearing surface can be disposed at equal intervals), and the plurality of routing grooves are each a circular groove which circles around the side circumferential surface of the soldering carrier and is perpendicular to the rotating shaft. The routing groove is used for routing the first strip-shaped conductive connection member when the first strip-shaped conductive connection member is wound around the side circumferential surface of the soldering carrier (the routing groove can restrict the first strip-shaped conductive connection member routed in the routing groove to extend in an identical direction to the routing groove). The two bearing surfaces are each provided with a vacuum adsorption function (for example, suction ports are uniformly distributed on each of the two bearing surfaces for a vacuum adsorption). The soldering carrier is provided with a heating function that can heat the two bearing surfaces.

Then the first strip-shaped conductive connection member is pre-placed by winding the first strip-shaped conductive connection member along a circumferential direction of the side circumferential surface of the soldering carrier and pulling the first strip-shaped conductive connection member tight to the side circumferential surface of the soldering carrier, where the first strip-shaped conductive connection member is routed in each routing groove, and the first strip-shaped conductive connection member is allowed to protrude from each routing groove (namely, the first strip-shaped conductive connection member is allowed to protrude from each bearing surface). Specifically, only one first strip-shaped conductive connection member may be used for winding. The first strip-shaped conductive connection member may be a flat solder ribbon. When the flat solder ribbon is wound, a bottom surface of the flat solder ribbon is allowed to face outwards to finally make the bottom surface of the flat solder ribbon face the inner side surface of the cell, such that finally, the flat solder ribbon is stably attached to the corresponding grid line on the inner side surface of the cell. When the first strip-shaped conductive connection member is wound, the side circumferential surface of the soldering carrier is enabled to rotate around the axis of the rotating shaft, making it convenient to wind the first strip-shaped conductive connection member. More specifically, an external mechanism (such as a motor) can be used to drive the rotating shaft to rotate around its own axis, and the rotating shaft drives the soldering carrier to rotate as a whole, such that the side circumferential surface of the soldering carrier is rotated around the axis of the rotating shaft.

Then a cell is attached to each of the two bearing surfaces. It is ensured that the cell does not extend beyond the respective bearing surface to which the cell is attached, and a side surface of the cell on which the first strip-shaped conductive connection member is to be soldered is allowed to face the respective bearing surface (namely, a side surface of the cell on which the second strip-shaped conductive connection member is to be soldered is allowed to be opposite to the respective bearing surface). An extension direction of the plurality of grid lines on the inner side surface of the cell (namely the side surface of the cell facing the respective bearing surface) is allowed to be perpendicular to the axis of the respective bearing surface (namely perpendicular to the axis of the rotating shaft). In addition, the plurality of grid lines on the inner side surface of the cell are correspondingly attached to the first strip-shaped conductive connection member protruding from the respective bearing surface in the plurality of routing grooves on the respective bearing surface. The vacuum adsorption is performed on the cell on the respective bearing surface through the respective bearing surface to ensure that the cell is stably absorbed on the respective bearing surface.

Then the second strip-shaped conductive connection member is tightened and attached to the outer side surface of the cell by winding the second strip-shaped conductive connection member along the circumferential direction of the side circumferential surface of the soldering carrier and pulling the second strip-shaped conductive connection member tight to the cell on the side circumferential surface of the soldering carrier, such that the second strip-shaped conductive connection member firmly presses the cell onto the first strip-shaped conductive connection member protruding from the respective bearing surface. When the second strip-shaped conductive connection member is wound, it is ensured that the second strip-shaped conductive connection member is correspondingly attached to the plurality of grid lines on the outer side surface of the cell. Specifically, only one second strip-shaped conductive connection member may be used for winding. The second strip-shaped conductive connection member may be a flat solder ribbon. When the flat solder ribbon is wound, a bottom surface of the flat solder ribbon is allowed to face the outer side surface of the cell, such that the flat solder ribbon is stably attached to the corresponding grid line on the outer side surface of the cell. When the second strip-shaped conductive connection member is wound, the side circumferential surface of the soldering carrier is enabled to rotate around the axis of the rotating shaft, which can facilitate the winding of the second strip-shaped conductive connection member. More specifically, an external mechanism (such as a motor) can be used to drive the rotating shaft to rotate around its own axis, and the rotating shaft drives the soldering carrier to rotate as a whole, such that the side circumferential surface of the soldering carrier is rotated around the axis of the rotating shaft.

Then the first strip-shaped conductive connection member and the second strip-shaped conductive connection member are heated, such that the first strip-shaped conductive connection member and the second strip-shaped conductive connection member are synchronously soldered on each cell. Specifically, 1) The first strip-shaped conductive connection member and the cell on each bearing surface and the second strip-shaped conductive connection member on the outer side surface of the cell can be heated through the soldering carrier, such that the first strip-shaped conductive connection member and the second strip-shaped conductive connection member are synchronously soldered on each cell. 2) It is also possible to heat each cell as well as the first strip-shaped conductive connection member and the second strip-shaped conductive connection member respectively on the two side surfaces of each cell through infrared heating (for example, by performing linear infrared irradiation on the outer side surface of each cell and the second strip-shaped conductive connection member on the outer side surface), such that the first strip-shaped conductive connection member and the second strip-shaped conductive connection member are synchronously soldered on each cell.

Then the first strip-shaped conductive connection member and the second strip-shaped conductive connection member are cut off to leave a small section of the first strip-shaped conductive connection member and a small section of the second strip-shaped conductive connection member on the cell, and the small section of the first strip-shaped conductive connection member and the small section of the second strip-shaped conductive connection member are configured for a serial connection of the cell on which the small section of the first strip-shaped conductive connection member and the small section of the second strip-shaped conductive connection member are located (one end of the small section of the first strip-shaped conductive connection member and one end of the small section of the second strip-shaped conductive connection member extend beyond the cell on which the small section of the first strip-shaped conductive connection member and the small section of the second strip-shaped conductive connection member are located, and the other end of the small section of the first strip-shaped conductive connection member and the other end of the small section of the second strip-shaped conductive connection member do not extend beyond the cell on which the small section of the first strip-shaped conductive connection member and the small section of the second strip-shaped conductive connection member are located).

Then the cell is removed from the respective bearing surface of the soldering carrier (the step of respectively soldering the strip-shaped conductive connection members to the two side surfaces of the cell is completed).

### Embodiment 2

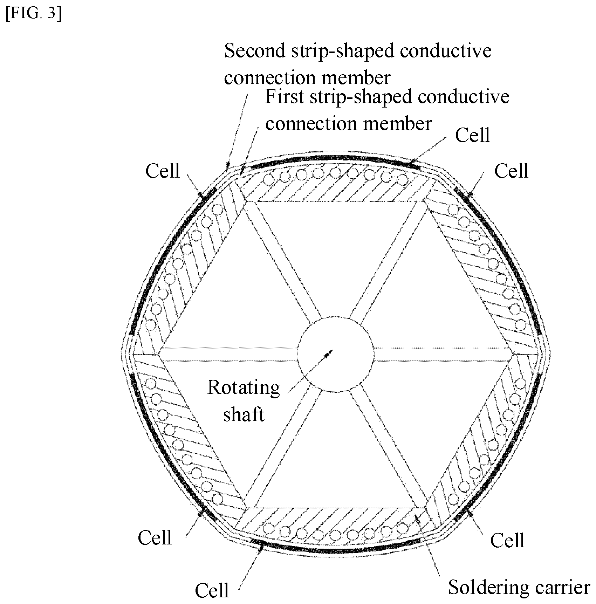

As shown in FIG. 3, this embodiment provides a double-sided soldering method for a solar cell, including: respectively soldering strip-shaped conductive connection members to two side surfaces of a cell (namely a front surface and a back surface of the cell), where the strip-shaped conductive connection members include a first strip-shaped conductive connection member and a second strip-shaped conductive connection member that are respectively disposed on the two side surfaces of the cell; an inner side surface of the cell is provided with a plurality of grid lines parallel to each other; and an outer side surface of the cell is also provided with a plurality of grid lines parallel to each other, and the plurality of grid lines on the outer side surface of the cell are parallel to the plurality of grid lines on the inner side surface of the cell.

The double-sided soldering method for the solar cell includes following steps.

A soldering carrier with a rotating shaft is provided, with an axis of the rotating shaft located on a centerline of the soldering carrier, and the soldering carrier is provided with a side circumferential surface around the rotating shaft. The side circumferential surface of the soldering carrier is surrounded by a plurality of bearing surfaces that can be used for attaching the cell (a main body of the soldering carrier may be a prism coaxial with the rotating shaft), where the plurality of bearing surfaces are outwardly protruding cambered surfaces (which may be arc surfaces) and an axis of each of the plurality of bearing surfaces is parallel to or collinear with the axis of the rotating shaft. The plurality of bearing surfaces are each provided with a plurality of routing grooves parallel to each other (the plurality of routing grooves on the respective bearing surface respectively correspond to the plurality of grid lines on the inner side surface of the cell attached to the respective bearing surface, and the plurality of routing grooves on the same bearing surface can be disposed at equal intervals), and the plurality of routing grooves are each a circular groove which circles around the side circumferential surface of the soldering carrier and is perpendicular to the rotating shaft. The routing groove is used for routing the first strip-shaped conductive connection member when the first strip-shaped conductive connection member is wound around the side circumferential surface of the soldering carrier (the routing groove can restrict the first strip-shaped conductive connection member routed in the routing groove to extend in an identical direction to the routing groove). The plurality of bearing surfaces are each provided with a vacuum adsorption function (for example, suction ports are uniformly distributed on each of the plurality of bearing surfaces for a vacuum adsorption). The soldering carrier is provided with a heating function that can heat the plurality of bearing surfaces.

Then the first strip-shaped conductive connection member is pre-placed by winding the first strip-shaped conductive connection member along a circumferential direction of the side circumferential surface of the soldering carrier and pulling the first strip-shaped conductive connection member tight to the side circumferential surface of the soldering carrier, where the first strip-shaped conductive connection member is routed in each routing groove, and the first strip-shaped conductive connection member is allowed to protrude from each routing groove (namely, the first strip-shaped conductive connection member is allowed to protrude from each bearing surface). Specifically, only one first strip-shaped conductive connection member may be used for winding. The first strip-shaped conductive connection member may be a round-wire solder ribbon. When the first strip-shaped conductive connection member is wound, the side circumferential surface of the soldering carrier is enabled to rotate around the axis of the rotating shaft, making it convenient to wind the first strip-shaped conductive connection member. More specifically, an external mechanism (such as a motor) can be used to drive the rotating shaft to rotate around its own axis, and the rotating shaft drives the soldering carrier to rotate as a whole, such that the side circumferential surface of the soldering carrier is rotated around the axis of the rotating shaft.

Then a cell is attached to each of the plurality of bearing surfaces. It is ensured that the cell does not extend beyond the respective bearing surface to which the cell is attached, and a side surface of the cell on which the first strip-shaped conductive connection member is to be soldered is allowed to face the respective bearing surface (namely, a side surface of the cell on which the second strip-shaped conductive connection member is to be soldered is allowed to be opposite to the respective bearing surface). An extension direction of the plurality of grid lines on the inner side surface of the cell (namely the side surface of the cell facing the respective bearing surface) is allowed to be perpendicular to the axis of the respective bearing surface (namely perpendicular to the axis of the rotating shaft). In addition, the plurality of grid lines on the inner side surface of the cell are correspondingly attached to the first strip-shaped conductive connection member protruding from the respective bearing surface in the plurality of routing grooves on the respective bearing surface. The vacuum adsorption is performed on the cell on the respective bearing surface through the respective bearing surface to ensure that the cell is stably absorbed on the respective bearing surface.

Then the second strip-shaped conductive connection member is tightened and attached to the outer side surface of the cell by winding the second strip-shaped conductive connection member along the circumferential direction of the side circumferential surface of the soldering carrier and pulling the second strip-shaped conductive connection member tight to the cell on the side circumferential surface of the soldering carrier, such that the second strip-shaped conductive connection member firmly presses the cell onto the first strip-shaped conductive connection member protruding from the respective bearing surface. When the second strip-shaped conductive connection member is wound, it is ensured that the second strip-shaped conductive connection member is correspondingly attached to the plurality of grid lines on the outer side surface of the cell. Specifically, only one second strip-shaped conductive connection member may be used for winding. The second strip-shaped conductive connection member may be a round-wire solder ribbon. When the second strip-shaped conductive connection member is wound, the side circumferential surface of the soldering carrier is enabled to rotate around the axis of the rotating shaft, making it convenient to wind the second strip-shaped conductive connection member. More specifically, an external mechanism (such as a motor) can be used to drive the rotating shaft to rotate around its own axis, and the rotating shaft drives the soldering carrier to rotate as a whole, such that the side circumferential surface of the soldering carrier is rotated around the axis of the rotating shaft.

Then the first strip-shaped conductive connection member and the second strip-shaped conductive connection member are heated, such that the first strip-shaped conductive connection member and the second strip-shaped conductive connection member are synchronously soldered on each cell. Specifically, 1) The first strip-shaped conductive connection member and the cell on each bearing surface and the second strip-shaped conductive connection member on the outer side surface of the cell can be heated through the soldering carrier, such that the first strip-shaped conductive connection member and the second strip-shaped conductive connection member are synchronously soldered on each cell. 2) It is also possible to heat each cell as well as the first strip-shaped conductive connection member and the second strip-shaped conductive connection member respectively on the two side surfaces of each cell through hot air heating (for example, by using hot air to blow the outer side surface of each cell and the second strip-shaped conductive connection member on the outer side surface), such that the first strip-shaped conductive connection member and the second strip-shaped conductive connection member are synchronously soldered on each cell.

Then the first strip-shaped conductive connection member and the second strip-shaped conductive connection member are cut off to leave a small section of the first strip-shaped conductive connection member and a small section of the second strip-shaped conductive connection member on the cell, and the small section of the first strip-shaped conductive connection member and the small section of the second strip-shaped conductive connection member are configured for a serial connection of the cell on which the small section of the first strip-shaped conductive connection member and the small section of the second strip-shaped conductive connection member are located (one end of the small section of the first strip-shaped conductive connection member and one end of the small section of the second strip-shaped conductive connection member extend beyond the cell on which the small section of the first strip-shaped conductive connection member and the small section of the second strip-shaped conductive connection member are located, and the other end of the small section of the first strip-shaped conductive connection member and the other end of the small section of the second strip-shaped conductive connection member do not extend beyond the cell on which the small section of the first strip-shaped conductive connection member and the small section of the second strip-shaped conductive connection member are located).

Then the cell is removed from the respective bearing surface of the soldering carrier (the step of respectively soldering the strip-shaped conductive connection members to the two side surfaces of the cell is completed).

### Embodiment 3

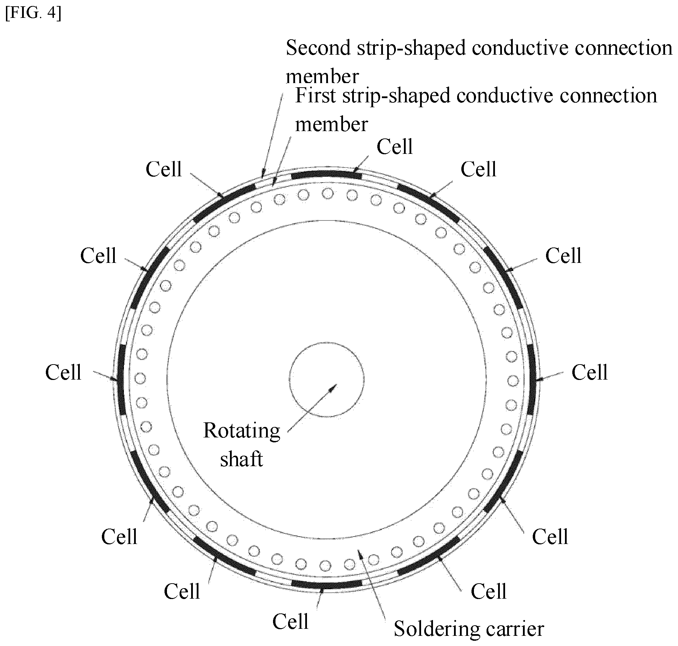

As shown in FIG. 4, this embodiment provides a double-sided soldering method for a solar cell, including: respectively soldering strip-shaped conductive connection members to two side surfaces of a cell (namely a front surface and a back surface of the cell), where the strip-shaped conductive connection members include a first strip-shaped conductive connection member and a second strip-shaped conductive connection member that are respectively disposed on the two side surfaces of the cell; an inner side surface of the cell is provided with a plurality of grid lines parallel to each other; and an outer side surface of the cell is also provided with a plurality of grid lines parallel to each other, and the plurality of grid lines on the outer side surface of the cell are parallel to the plurality of grid lines on the inner side surface of the cell.

The double-sided soldering method for the solar cell includes following steps.

A soldering carrier with a rotating shaft is provided, with an axis of the rotating shaft located on a centerline of the soldering carrier, and the soldering carrier is provided with a side circumferential surface around the rotating shaft. The side circumferential surface of the soldering carrier is a circumferential surface coaxial with the rotating shaft (a main body of the soldering carrier may be a cylinder coaxial with the rotating shaft). The side circumferential surface of the soldering carrier is sequentially divided into a plurality of cambered areas at intervals along a circumferential direction of the side circumferential surface of the soldering carrier, and the plurality of cambered areas are uniformly distributed along the circumferential direction of the side circumferential surface of the soldering carrier. The plurality of cambered areas are a plurality of bearing surfaces that can be used for attaching the cell. The plurality of bearing surfaces are each provided with a plurality of routing grooves parallel to each other (the plurality of routing grooves on the respective bearing surface respectively correspond to the plurality of grid lines on the inner side surface of the cell attached to the respective bearing surface, and the plurality of routing grooves on the same bearing surface can be disposed at equal intervals), and the plurality of routing grooves are each a circular groove which circles around the side circumferential surface of the soldering carrier and is coaxial with the rotating shaft. The plurality of routing grooves are each a V-shaped groove into which a top corner of a triangular solder ribbon can be embedded. The routing groove is used for routing the first strip-shaped conductive connection member (the triangular solder ribbon) when the first strip-shaped conductive connection member (the triangular solder ribbon) is wound around the side circumferential surface of the soldering carrier (the routing groove can restrict the first strip-shaped conductive connection member/the triangular solder ribbon routed in the routing groove to extend in an identical direction to the routing groove). The plurality of bearing surfaces are each provided with a vacuum adsorption function (for example, suction ports are uniformly distributed on each of the plurality of bearing surfaces for a vacuum adsorption). The soldering carrier is provided with a heating function that can heat the plurality of bearing surfaces.

Then the first strip-shaped conductive connection member is pre-placed by winding the first strip-shaped conductive connection member along the circumferential direction of the side circumferential surface of the soldering carrier and pulling the first strip-shaped conductive connection member tight to the side circumferential surface of the soldering carrier, where the first strip-shaped conductive connection member is routed in each routing groove, and the first strip-shaped conductive connection member is allowed to protrude from each routing groove (namely, the first strip-shaped conductive connection member is allowed to protrude from each bearing surface). Specifically, only one first strip-shaped conductive connection member may be used for winding. The first strip-shaped conductive connection member may be the triangular solder ribbon. When the triangular solder ribbon is wound, the top corner of the triangular solder ribbon is embedded into the routing groove (the V-shaped groove), and a flat-placed bottom surface of the triangular solder ribbon is allowed to protrude from the routing groove. The routing groove (the V-shaped groove) is configured to support the triangular solder ribbon routed in the routing groove to keep the bottom surface of the triangular solder ribbon facing outwards, so as to prevent the triangular solder ribbon from twisting when being routed in the routing groove. This can ultimately allow the bottom surface of the triangular solder ribbon to face the inner side surface of the cell, such that finally, the first strip-shaped conductive connection member (the triangular solder ribbon) can be stably attached to the corresponding grid line on the inner side surface of the cell. When the first strip-shaped conductive connection member is wound, the side circumferential surface of the soldering carrier is enabled to rotate around the axis of the rotating shaft, making it convenient to wind the first strip-shaped conductive connection member. More specifically, an external mechanism (such as a motor) can be used to drive the rotating shaft to rotate around its own axis, and the rotating shaft drives the soldering carrier to rotate as a whole, such that the side circumferential surface of the soldering carrier is rotated around the axis of the rotating shaft.

Then a cell is attached to each of the plurality of bearing surfaces. It is ensured that the cell does not extend beyond the respective bearing surface to which the cell is attached, and a side surface of the cell on which the first strip-shaped conductive connection member is to be soldered is allowed to face the respective bearing surface (namely, a side surface of the cell on which the second strip-shaped conductive connection member is to be soldered is allowed to be opposite to the respective bearing surface). An extension direction of the plurality of grid lines on the inner side surface of the cell (namely the side surface of the cell facing the respective bearing surface) is allowed to be perpendicular to an axis of the respective bearing surface (namely perpendicular to the axis of the rotating shaft). In addition, the plurality of grid lines on the inner side surface of the cell are correspondingly attached to the first strip-shaped conductive connection member protruding from the respective bearing surface in the plurality of routing grooves on the respective bearing surface. The vacuum adsorption is performed on the cell on the respective bearing surface through the respective bearing surface to ensure that the cell is stably absorbed on the respective bearing surface.

Then the second strip-shaped conductive connection member is tightened and attached to the outer side surface of the cell by winding the second strip-shaped conductive connection member along the circumferential direction of the side circumferential surface of the soldering carrier and pulling the second strip-shaped conductive connection member tight to the cell on the side circumferential surface of the soldering carrier, such that the second strip-shaped conductive connection member firmly presses the cell onto the first strip-shaped conductive connection member protruding from the respective bearing surface. When the second strip-shaped conductive connection member is wound, it is ensured that the second strip-shaped conductive connection member is correspondingly attached to the plurality of grid lines on the outer side surface of the cell. Specifically, only one second strip-shaped conductive connection member may be used for winding. The second strip-shaped conductive connection member may be the triangular solder ribbon. When the triangular solder ribbon is wound, the bottom surface of the triangular solder ribbon is allowed to face the outer side surface of the cell (that is, the top corner of the triangular solder ribbon is opposite to the outer sider surface of the cell), such that the triangular solder ribbon is stably attached to the corresponding grid line on the outer side surface of the cell. In addition, in a process of winding the triangular solder ribbon, a state in which the bottom surface of the triangular solder ribbon is attached to the outer side surface of the cell is the most stable. Therefore, in the winding process, a direction of the top corner of the triangular solder ribbon can be automatically corrected, such that the top corner faces upwards and the bottom surface faces downwards. In this way, the triangular solder ribbon is stably attached to the outer side surface of the cell. When the second strip-shaped conductive connection member is wound, the side circumferential surface of the soldering carrier is enabled to rotate around the axis of the rotating shaft, making it convenient to wind the second strip-shaped conductive connection member. More specifically, an external mechanism (such as a motor) can be used to drive the rotating shaft to rotate around its own axis, and the rotating shaft drives the soldering carrier to rotate as a whole, such that the side circumferential surface of the soldering carrier is rotated around the axis of the rotating shaft.

Then the first strip-shaped conductive connection member and the second strip-shaped conductive connection member are heated, such that the first strip-shaped conductive connection member and the second strip-shaped conductive connection member are synchronously soldered on each cell. Specifically, 1) The first strip-shaped conductive connection member and the cell on each bearing surface and the second strip-shaped conductive connection member on the outer side surface of the cell can be heated through the soldering carrier, such that the first strip-shaped conductive connection member and the second strip-shaped conductive connection member are synchronously soldered on each cell. 2) It is also possible to heat each cell as well as the first strip-shaped conductive connection member and the second strip-shaped conductive connection member respectively on the two side surfaces of each cell through hot air heating (for example, by using hot air to blow the outer side surface of each cell and the second strip-shaped conductive connection member on the outer side surface), such that the first strip-shaped conductive connection member and the second strip-shaped conductive connection member are synchronously soldered on each cell.

Then the first strip-shaped conductive connection member and the second strip-shaped conductive connection member are cut off to leave a small section of the first strip-shaped conductive connection member and a small section of the second strip-shaped conductive connection member on the cell, and the small section of the first strip-shaped conductive connection member and the small section of the second strip-shaped conductive connection member are configured for a serial connection of the cell on which the small section of the first strip-shaped conductive connection member and the small section of the second strip-shaped conductive connection member are located (one end of the small section of the first strip-shaped conductive connection member and one end of the small section of the second strip-shaped conductive connection member extend beyond the cell on which the small section of the first strip-shaped conductive connection member and the small section of the second strip-shaped conductive connection member are located, and the other end of the small section of the first strip-shaped conductive connection member and the other end of the small section of the second strip-shaped conductive connection member do not extend beyond the cell on which the small section of the first strip-shaped conductive connection member and the small section of the second strip-shaped conductive connection member are located).

Then the cell is removed from the respective bearing surface of the soldering carrier (the step of respectively soldering the strip-shaped conductive connection members to the two side surfaces of the cell is completed).

### Embodiment 4

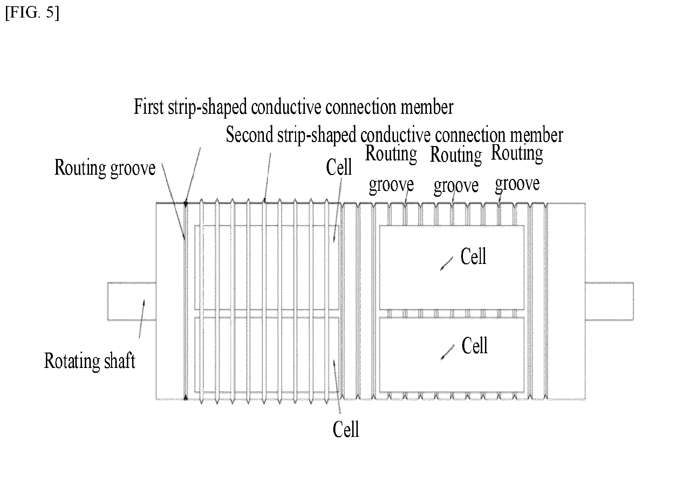

As shown in FIG. 5, this embodiment provides a double-sided soldering method for a solar cell, including: respectively soldering strip-shaped conductive connection members to two side surfaces of a cell (namely a front surface and a back surface of the cell), where the strip-shaped conductive connection members include a first strip-shaped conductive connection member and a second strip-shaped conductive connection member that are respectively disposed on the two side surfaces of the cell; an inner side surface of the cell is provided with a plurality of grid lines parallel to each other; and an outer side surface of the cell is also provided with a plurality of grid lines parallel to each other, and the plurality of grid lines on the outer side surface of the cell are parallel to the plurality of grid lines on the inner side surface of the cell.

The double-sided soldering method for the solar cell includes following steps.

A soldering carrier with a rotating shaft is provided, with an axis of the rotating shaft located on a centerline of the soldering carrier, and the soldering carrier is provided with a side circumferential surface around the rotating shaft. The side circumferential surface of the soldering carrier is a circumferential surface coaxial with the rotating shaft (a main body of the soldering carrier may be a cylinder coaxial with the rotating shaft). The side circumferential surface of the soldering carrier is divided into a plurality of rows of cambered areas. The plurality of rows of cambered areas are sequentially disposed at intervals along a circumferential direction of the side circumferential surface of the soldering carrier, and cambered areas in an identical row of the plurality of rows of cambered areas are sequentially disposed at intervals along an axial direction of the rotating shaft. The plurality of rows of cambered areas are a plurality of bearing surfaces that can be used for attaching the cell. The plurality of bearing surfaces are each provided with a plurality of routing grooves parallel to each other (the plurality of routing grooves on the respective bearing surface respectively correspond to the plurality of grid lines on the inner side surface of the cell attached to the respective bearing surface, and the plurality of routing grooves on the same bearing surface can be disposed at equal intervals), and the plurality of routing grooves are each a circular groove which circles around the side circumferential surface of the soldering carrier and is coaxial with the rotating shaft. The plurality of routing grooves are each a V-shaped groove into which a top corner of a triangular solder ribbon can be embedded. The routing groove is used for routing the first strip-shaped conductive connection member (the triangular solder ribbon) when the first strip-shaped conductive connection member (the triangular solder ribbon) is wound around the side circumferential surface of the soldering carrier (the routing groove can restrict the first strip-shaped conductive connection member/the triangular solder ribbon routed in the routing groove to extend in an identical direction to the routing groove). The plurality of bearing surfaces are each provided with a vacuum adsorption function (for example, suction ports are uniformly distributed on each of the plurality of bearing surfaces for a vacuum adsorption). The soldering carrier is provided with a heating function that can heat the plurality of bearing surfaces.

Then the first strip-shaped conductive connection member is pre-placed by winding the first strip-shaped conductive connection member along the circumferential direction of the side circumferential surface of the soldering carrier and pulling the first strip-shaped conductive connection member tight to the side circumferential surface of the soldering carrier, where the first strip-shaped conductive connection member is routed in each routing groove, and the first strip-shaped conductive connection member is allowed to protrude from each routing groove (namely, the first strip-shaped conductive connection member is allowed to protrude from each bearing surface). Specifically, only one first strip-shaped conductive connection member may be used for winding. The first strip-shaped conductive connection member may be the triangular solder ribbon. When the triangular solder ribbon is wound, the top corner of the triangular solder ribbon is embedded into the routing groove (the V-shaped groove), and a flat-placed bottom surface of the triangular solder ribbon is allowed to protrude from the routing groove. The routing groove (the V-shaped groove) is configured to support the triangular solder ribbon routed in the routing groove to keep the bottom surface of the triangular solder ribbon facing outwards, so as to prevent the triangular solder ribbon from twisting when being routed in the routing groove. This can ultimately allow the bottom surface of the triangular solder ribbon to face the inner side surface of the cell, such that finally, the first strip-shaped conductive connection member (the triangular solder ribbon) can be stably attached to the corresponding grid line on the inner side surface of the cell. When the first strip-shaped conductive connection member is wound, the side circumferential surface of the soldering carrier is enabled to rotate around the axis of the rotating shaft, making it convenient to wind the first strip-shaped conductive connection member. More specifically, an external mechanism (such as a motor) can be used to drive the rotating shaft to rotate around its own axis, and the rotating shaft drives the soldering carrier to rotate as a whole, such that the side circumferential surface of the soldering carrier is rotated around the axis of the rotating shaft.

Then a cell is attached to each of the plurality of bearing surfaces. It is ensured that the cell does not extend beyond the respective bearing surface to which the cell is attached, and a side surface of the cell on which the first strip-shaped conductive connection member is to be soldered is allowed to face the respective bearing surface (namely, a side surface of the cell on which the second strip-shaped conductive connection member is to be soldered is allowed to be opposite to the respective bearing surface). An extension direction of the plurality of grid lines on the inner side surface of the cell (namely the side surface of the cell facing the respective bearing surface) is allowed to be perpendicular to an axis of the respective bearing surface (namely perpendicular to the axis of the rotating shaft). In addition, the plurality of grid lines on the inner side surface of the cell are correspondingly attached to the first strip-shaped conductive connection member protruding from the respective bearing surface in the plurality of routing grooves on the respective bearing surface. The vacuum adsorption is performed on the cell on the respective bearing surface through the respective bearing surface to ensure that the cell is stably absorbed on the respective bearing surface.

Then the second strip-shaped conductive connection member is tightened and attached to the outer side surface of the cell by winding the second strip-shaped conductive connection member along the circumferential direction of the side circumferential surface of the soldering carrier and pulling the second strip-shaped conductive connection member tight to the cell on the side circumferential surface of the soldering carrier, such that the second strip-shaped conductive connection member firmly presses the cell onto the first strip-shaped conductive connection member protruding from the respective bearing surface. When the second strip-shaped conductive connection member is wound, it is ensured that the second strip-shaped conductive connection member is correspondingly attached to the plurality of grid lines on the outer side surface of the cell. Specifically, only one second strip-shaped conductive connection member may be used for winding. The second strip-shaped conductive connection member may be the triangular solder ribbon. When the triangular solder ribbon is wound, the bottom surface of the triangular solder ribbon is allowed to face the outer side surface of the cell (that is, the top corner of the triangular solder ribbon is opposite to the outer sider surface of the cell), such that the triangular solder ribbon is stably attached to the corresponding grid line on the outer side surface of the cell. In addition, in a process of winding the triangular solder ribbon, a state in which the bottom surface of the triangular solder ribbon is attached to the outer side surface of the cell is the most stable. Therefore, in the winding process, a direction of the top corner of the triangular solder ribbon can automatically corrected, such that the top corner faces upwards and the bottom surface faces downwards. In this way, the triangular solder ribbon is stably attached to the outer side surface of the cell. When the second strip-shaped conductive connection member is wound, the side circumferential surface of the soldering carrier is enabled to rotate around the axis of the rotating shaft, making it convenient to wind the second strip-shaped conductive connection member. More specifically, an external mechanism (such as a motor) can be used to drive the rotating shaft to rotate around its own axis, and the rotating shaft drives the soldering carrier to rotate as a whole, such that the side circumferential surface of the soldering carrier is rotated around the axis of the rotating shaft.

Then the first strip-shaped conductive connection member and the second strip-shaped conductive connection member are heated, such that the first strip-shaped conductive connection member and the second strip-shaped conductive connection member are synchronously soldered on each cell. Specifically, 1) The first strip-shaped conductive connection member and the cell on each bearing surface and the second strip-shaped conductive connection member on the outer side surface of the cell can be heated through the soldering carrier, such that the first strip-shaped conductive connection member and the second strip-shaped conductive connection member are synchronously soldered on each cell. 2) It is also possible to heat each cell as well as the first strip-shaped conductive connection member and the second strip-shaped conductive connection member respectively on the two side surfaces of each cell through infrared heating (for example, by performing linear infrared irradiation on the outer side surface of each cell and the second strip-shaped conductive connection member on the outer side surface), such that the first strip-shaped conductive connection member and the second strip-shaped conductive connection member are synchronously soldered on each cell.

Then the first strip-shaped conductive connection member and the second strip-shaped conductive connection member are cut off to leave a small section of the first strip-shaped conductive connection member and a small section of the second strip-shaped conductive connection member on the cell, and the small section of the first strip-shaped conductive connection member and the small section of the second strip-shaped conductive connection member are configured for a serial connection of the cell on which the small section of the first strip-shaped conductive connection member and the small section of the second strip-shaped conductive connection member are located (one end of the small section of the first strip-shaped conductive connection member and one end of the small section of the second strip-shaped conductive connection member extend beyond the cell on which the small section of the first strip-shaped conductive connection member and the small section of the second strip-shaped conductive connection member are located, and the other end of the small section of the first strip-shaped conductive connection member and the other end of the small section of the second strip-shaped conductive connection member do not extend beyond the cell on which the small section of the first strip-shaped conductive connection member and the small section of the second strip-shaped conductive connection member are located).

Then the cell is removed from the respective bearing surface of the soldering carrier (the step of respectively soldering the strip-shaped conductive connection members to the two side surfaces of the cell is completed).

**In** Embodiment 4, the strip-shaped conductive connection members (the first strip-shaped conductive connection member and the second strip-shaped conductive connection member) can be wound and soldered to a plurality of rows of cells at a time, and the strip-shaped conductive connection members (the first strip-shaped conductive connection member and the second strip-shaped conductive connection member) can be soldered to the two side surfaces of each cell of the plurality of rows of cells at a time, thereby improving the soldering efficiency.

The above description is only preferred implementations of the present disclosure. It should be noted that those skilled in the art can make several improvements and modifications without departing from the technical principles of the present disclosure, and these improvements and modifications should also be construed as falling within the protection scope of the present disclosure.

## Claims

1. A double-sided soldering method for a solar cell, **characterized by** comprising following steps:
providing, on an outer surface of a soldering carrier, a bearing surface for attaching a cell, enabling the bearing surface to be an outwardly protruding cambered surface, and disposing a routing groove for placing a first strip-shaped conductive connection member on the bearing surface, wherein the routing groove is extended along a circumferential direction of the bearing surface and the routing groove is a through groove;
pre-placing the first strip-shaped conductive connection member, wherein the first strip-shaped conductive connection member is routed in the routing groove, and the first strip-shaped conductive connection member is allowed to protrude from the routing groove;
attaching the cell to the bearing surface, allowing a side surface of the cell to face the bearing surface to be an inner side surface of the cell, and attaching the inner side surface of the cell to the first strip-shaped conductive connection member, wherein the first strip-shaped conductive connection member is to be soldered on the side surface of the cell;
tightening and attaching a second strip-shaped conductive connection member to an outer side surface of the cell; and
heating the first strip-shaped conductive connection member and the second strip-shaped conductive connection member, such that the first strip-shaped conductive connection member and the second strip-shaped conductive connection member are soldered on the cell.

2. The double-sided soldering method for the solar cell according to claim 1, **characterized in that** the inner side surface of the cell is provided with a plurality of grid lines parallel to each other;
the bearing surface is provided with a plurality of routing grooves parallel to each other, wherein the plurality of routing grooves are each extended along the circumferential direction of the bearing surface and each of the plurality of routing grooves is a through groove;
when the first strip-shaped conductive connection member is pre-placed, the first strip-shaped conductive connection member is routed in each of the plurality of routing grooves, and the first strip-shaped conductive connection member is allowed to protrude from a routing groove of the plurality of routing grooves in which the first strip-shaped conductive connection member is located; and
when the cell is attached to the bearing surface, an extension direction of the plurality of grid lines on the inner side surface of the cell is allowed to be perpendicular to an axis of the bearing surface, and the plurality of grid lines on the inner side surface of the cell are correspondingly attached to the first strip-shaped conductive connection member in the plurality of routing grooves on the bearing surface.

3. The double-sided soldering method for the solar cell according to claim 2, **characterized in that** the outer side surface of the cell is provided with a plurality of grid lines parallel to each other; and
when the second strip-shaped conductive connection member is tightened and attached to the outer side surface of the cell, the second strip-shaped conductive connection member is correspondingly attached to the plurality of grid lines on the outer side surface of the cell.

4. The double-sided soldering method for the solar cell according to claim 1, 2, or 3, **characterized in that** the second strip-shaped conductive connection member is tightened and attached to the outer side surface of the cell by allowing the second strip-shaped conductive connection member to span across the cell along the circumferential direction of the bearing surface and pulling sections of the second strip-shaped conductive connection member respectively located outside two sides of the cell tight towards the soldering carrier.

5. The double-sided soldering method for the solar cell according to claim 1, 2, or 3, **characterized in that** a rotating shaft is provided on the soldering carrier, and the outer surface of the soldering carrier comprises a side circumferential surface around the rotating shaft, and the bearing surface is located on the side circumferential surface of the soldering carrier, and an axis of the bearing surface is parallel to or collinear with an axis of the rotating shaft; and
the first strip-shaped conductive connection member is pre-placed by routing and winding the first strip-shaped conductive connection member along the routing groove and pulling the first strip-shaped conductive connection member tight to the side circumferential surface of the soldering carrier.

6. The double-sided soldering method for the solar cell according to claim 5, **characterized in that** the second strip-shaped conductive connection member is tightened and attached to the outer side surface of the cell by winding the second strip-shaped conductive connection member along a circumferential direction of the side circumferential surface of the soldering carrier and pulling the second strip-shaped conductive connection member tight to the cell on the side circumferential surface of the soldering carrier.

7. The double-sided soldering method for the solar cell according to claim 6, **characterized in that** the axis of the rotating shaft is located on a centerline of the soldering carrier.

8. The double-sided soldering method for the solar cell according to claim 6, **characterized in that** when the first strip-shaped conductive connection member is wound along the routing groove and pulled tight to the side circumferential surface of the soldering carrier, the side circumferential surface of the soldering carrier is rotated around the axis of the rotating shaft; and
when the second strip-shaped conductive connection member is wound along the circumferential direction of the side circumferential surface of the soldering carrier and pulled tight to the cell on the side circumferential surface of the soldering carrier, the side circumferential surface of the soldering carrier is rotated around the axis of the rotating shaft.

9. The double-sided soldering method for the solar cell according to claim 6, **characterized in that** at least two bearing surfaces are provided on the side circumferential surface of the soldering carrier and are each provided with a routing groove, and an axis of each of the at least two bearing surfaces is parallel to or collinear with the axis of the rotating shaft;
the first strip-shaped conductive connection member is pre-placed by winding the first strip-shaped conductive connection member along the circumferential direction of the side circumferential surface of the soldering carrier and pulling the first strip-shaped conductive connection member tight to the side circumferential surface of the soldering carrier, and the first strip-shaped conductive connection member is routed in the routing groove;
a cell is attached to each of the at least two bearing surfaces, a side surface of the cell on which the first strip-shaped conductive connection member is to be soldered is allowed to face a respective bearing surface of the at least two bearing surfaces to be an inner side surface of the cell, and the inner side surface of the cell is attached to the first strip-shaped conductive connection member;
the second strip-shaped conductive connection member is tightened and attached to an outer side surface of the cell by winding the second strip-shaped conductive connection member along the circumferential direction of the side circumferential surface of the soldering carrier and pulling the second strip-shaped conductive connection member tight to the cell on the side circumferential surface of the soldering carrier; and
the first strip-shaped conductive connection member and the second strip-shaped conductive connection member are heated, such that the first strip-shaped conductive connection member and the second strip-shaped conductive connection member are soldered on the cell.

10. The double-sided soldering method for the solar cell according to claim 9, **characterized in that** a plurality of bearing surfaces are provided on the side circumferential surface of the soldering carrier and are each provided with a routing groove, and the plurality of bearing surfaces are sequentially disposed along the circumferential direction of the side circumferential surface of the soldering carrier.

11. The double-sided soldering method for the solar cell according to claim 10, **characterized in that** the plurality of bearing surfaces are uniformly distributed along the circumferential direction of the side circumferential surface of the soldering carrier.

12. The double-sided soldering method for the solar cell according to claim 9, **characterized in that** a plurality of rows of bearing surfaces are provided on the side circumferential surface of the soldering carrier and are each provided with a routing groove, and the plurality of rows of bearing surfaces are sequentially disposed along the circumferential direction of the side circumferential surface of the soldering carrier, bearing surfaces in an identical row of the plurality of rows of bearing surfaces are sequentially disposed along an axial direction of the rotating shaft, and an axis of each bearing surface of the plurality of rows of bearing surfaces is parallel to or collinear with the axis of the rotating shaft.

13. The double-sided soldering method for the solar cell according to claim 12, **characterized in that** the plurality of rows of bearing surfaces are uniformly distributed along the circumferential direction of the side circumferential surface of the soldering carrier.

14. The double-sided soldering method for the solar cell according to claim 13, **characterized in that** the plurality of rows of bearing surfaces are uniformly distributed on the side circumferential surface of the soldering carrier.

15. The double-sided soldering method for the solar cell according to claim 9, **characterized in that** the side circumferential surface of the soldering carrier is surrounded by the at least two bearing surfaces.

16. The double-sided soldering method for the solar cell according to claim 15, **characterized in that** the side circumferential surface of the soldering carrier is coaxial with the rotating shaft.

17. The double-sided soldering method for the solar cell according to claim 9, **characterized in that** the side circumferential surface of the soldering carrier is a circumferential surface coaxial with the rotating shaft.

18. The double-sided soldering method for the solar cell according to claim 17, **characterized in that** the routing groove is a circular groove coaxial with the rotating shaft.

19. The double-sided soldering method for the solar cell according to claim 6, **characterized in that** one first strip-shaped conductive connection member is used, and the one first strip-shaped conductive connection member is routed and wound along the routing groove and pulled tight to the side circumferential surface of the soldering carrier; and
one second strip-shaped conductive connection member is used, and the one second strip-shaped conductive connection member is wound along the circumferential direction of the side circumferential surface of the soldering carrier and pulled tight to the cell on the side circumferential surface of the soldering carrier.

20. The double-sided soldering method for the solar cell according to claim 1, **characterized in that** the first strip-shaped conductive connection member and the second strip-shaped conductive connection member are each a solder wire or a solder ribbon.

21. The double-sided soldering method for the solar cell according to claim 1, **characterized in that** each of the first strip-shaped conductive connection member and the second strip-shaped conductive connection member has a flat and straight bottom surface for soldering to the cell;
when the first strip-shaped conductive connection member is pre-placed, the flat and straight bottom surface of the first strip-shaped conductive connection member is arranged to be opposite to the bearing surface; and
when the second strip-shaped conductive connection member is tightened and attached to the outer side surface of the cell, the flat and straight bottom surface of the second strip-shaped conductive connection member is allowed to face the outer side surface of the cell.

22. The double-sided soldering method for the solar cell according to claim 21, **characterized in that** the routing groove is configured to support the first strip-shaped conductive connection member routed in the routing groove to keep the flat and straight bottom surface of the first strip-shaped conductive connection member being opposite to the bearing surface.

23. The double-sided soldering method for the solar cell according to claim 22, **characterized in that** the first strip-shaped conductive connection member is a triangular solder ribbon, the routing groove is a V-shaped groove, and when the first strip-shaped conductive connection member is routed in the routing groove, a top corner of the first strip-shaped conductive connection member is embedded into the routing groove, and the flat and straight bottom surface of the first strip-shaped conductive connection member is allowed to protrude from the routing groove.

24. The double-sided soldering method for the solar cell according to claim 1, **characterized in that** the first strip-shaped conductive connection member and the second strip-shaped conductive connection member are heated through direct heating, infrared heating, or hot air heating.

25. The double-sided soldering method for the solar cell according to claim 24, **characterized in that** the soldering carrier is provided with a heating function, and the first strip-shaped conductive connection member and the cell on the bearing surface and the second strip-shaped conductive connection member on the outer side surface of the cell are heated through the soldering carrier.

26. The double-sided soldering method for the solar cell according to claim 1, **characterized in that** the bearing surface is provided with a vacuum adsorption function, and a vacuum adsorption is performed on the cell when the cell is attached to the bearing surface.

27. The double-sided soldering method for the solar cell according to claim 1, **characterized in that** after the first strip-shaped conductive connection member and the second strip-shaped conductive connection member are soldered on the cell, the first strip-shaped conductive connection member and the second strip-shaped conductive connection member are cut off to leave a small section of the first strip-shaped conductive connection member and a small section of the second strip-shaped conductive connection member on the cell, and the small section of the first strip-shaped conductive connection member and the small section of the second strip-shaped conductive connection member are configured for a serial connection of the cell on which the small section of the first strip-shaped conductive connection member and the small section of the second strip-shaped conductive connection member are located, and then the cell is removed from the bearing surface of the soldering carrier.
